# EUROPÄISCHE PATENTANMELDUNG

(11) **EP 3 859 897 A1**
(43) Veröffentlichungstag der Anmeldung: **04.08.2021**
(21) Anmeldenummer: 21151596.0
(22) Anmeldetag: 14.01.2021
(51) Int. Cl.: H01R 12/57, H01R 13/11, H01R 43/20, H01R 12/71, H05K 3/32, H05K 3/40

(54) **ELEKTRISCHE KONTAKTVORRICHTUNG FÜR EINE LEITERPLATTE**

(30) Priorität: 30.01.2020 DE 102020102270; 14.08.2020 DE 102020121477
(71) Anmelder: SERO GmbH, 76865 Rohrbach (DE)
(72) Erfinder: Starck, Wolfgang, 76889 Birkenhördt (DE)
(74) Vertreter: Patentanwälte Bregenzer und Reule Partnerschaftsgesellschaft mbB

(57) **Zusammenfassung**

Die Erfindung betrifft eine elektrische Kontaktvorrichtung zur Herstellung einer elektrischen Verbindung zwischen einem Steckkontakt (200) und einer Leiterplatte (80), wobei die Kontaktvorrichtung (20) eine Steckaufnahme (21) zum Einstecken des Steckkontakts (200) und einen Befestigungsflansch (22) zur Befestigung der Kontaktvorrichtung (20) an der Leiterplatte (80) aufweist, wobei sich der Befestigungsflansch (22) ringförmig um die Steckaufnahme (21) erstreckt und an einander entgegengesetzten Seiten eine Stützfläche (23) zur flächigen Abstützung an der Leiterplatte (80) und eine Ansaugfläche (24) zum Ansaugen durch ein Bestückungswerkzeug (300) aufweist, das zum Bestücken der Leiterplatte (80) mit der Kontaktvorrichtung (20) vorgesehen ist, wobei die Kontaktvorrichtung (20) eine Kontaktzungenanordnung (30) mit federnd nachgiebigen Kontaktzungen (31) aufweist, die winkelig zu der Stützfläche (23) in Richtung der Steckaufnahme (21) zur Anlage an dem Steckkontakt (200) vorstehen, wobei die Kontaktzungen (31) in Winkelabständen zueinander rings um die Steckaufnahme (21) angeordnet sind.

## Beschreibung

Die Erfindung betrifft eine elektrische Kontaktvorrichtung zur Herstellung einer elektrischen Verbindung zwischen einem Steckkontakt und einer Leiterplatte. Die Erfindung betrifft ferner ein Verfahren zur Herstellung einer elektrischen Vorrichtung umfassend eine Leiterplatte und eine Kontaktvorrichtung.

Derartige Kontaktvorrichtungen werden beispielsweise dazu benötigt, elektrische Steckverbinder mit einer Leiterplatte zu verbinden. Die Kontaktvorrichtung wird fest mit der Leiterplatte verbunden und stellt eine Steckaufnahme bereit, in die ein Steckkontakt einsteckbar ist.

Ein wesentlicher Aspekt bei derartigen Kontaktvorrichtungen ist deren Handhabbarkeit zur Bestückung einer Leiterplatte. Beispielsweise werden Bestückungswerkzeuge in Gestalt von Saugeinrichtungen verwendet, die die Kontaktvorrichtung ansaugen und auf der Leiterplatte an der geeigneten Stelle für den anschließenden Lötprozess platzieren. Dazu bedarf es einer zu Ansaugung geeigneten Oberfläche an der Kontaktvorrichtung.

Es ist daher die Aufgabe der vorliegenden Erfindung, eine für eine einfache Bestückung einer Leiterplatte geeignete elektrische Kontaktvorrichtung bereitzustellen sowie ein geeignetes Verfahren aufzuzeigen.

Zur Lösung der Aufgabe ist eine elektrische Kontaktvorrichtung zur Herstellung einer elektrischen Verbindung zwischen einem Steckkontakt und einer Leiterplatte vorgesehen, wobei die Kontaktvorrichtung eine Steckaufnahme zum Einstecken des Steckkontakts und einen Befestigungsflansch zur Befestigung der Kontaktvorrichtung an der Leiterplatte aufweist, wobei sich der Befestigungsflansch ringförmig um die Steckaufnahme erstreckt und an einander entgegengesetzten Seiten eine Stützfläche zur flächigen Abstützung an der Leiterplatte und eine Ansaugfläche zum Ansaugen durch ein Bestückungswerkzeug aufweist, das zum Bestücken der Leiterplatte mit der Kontaktvorrichtung vorgesehen ist, wobei die Kontaktvorrichtung eine Kontaktzungenanordnung mit federnd nachgiebigen Kontaktzungen aufweist, die winkelig zu der Stützfläche in Richtung der Steckaufnahme zur Anlage an dem Steckkontakt vorstehen, wobei die Kontaktzungen in Winkelabständen zueinander rings um die Steckaufnahme angeordnet sind.

Das erfindungsgemäße Verfahren lässt sich wie folgt definieren:
Verfahren zur Herstellung einer elektrischen Vorrichtung umfassend eine Leiterplatte und mindestens eine Kontaktvorrichtung zur Herstellung einer elektrischen Verbindung zwischen einem Steckkontakt und der Leiterplatte, wobei die Kontaktvorrichtung eine Steckaufnahme zum Einstecken des Steckkontakts und einen Befestigungsflansch zur Befestigung der Kontaktvorrichtung an der Leiterplatte aufweist, wobei sich der Befestigungsflansch ringförmig um die Steckaufnahme erstreckt und an einander entgegengesetzten Seiten eine Stützfläche zur flächigen Abstützung an der Leiterplatte und eine Ansaugfläche zum Ansaugen durch ein Bestückungswerkzeug aufweist, das zum Bestücken der Leiterplatte mit der Kontaktvorrichtung vorgesehen ist, wobei die Kontaktvorrichtung eine Kontaktzungenanordnung mit federnd nachgiebigen Kontaktzungen aufweist, die winkelig zu der Stützfläche in Richtung der Steckaufnahme zur Anlage an dem Steckkontakt vorstehen, wobei die Kontaktzungen in Winkelabständen zueinander rings um die Steckaufnahme angeordnet sind, umfassend:
- Ansaugen der Kontaktvorrichtung anhand des Bestückungswerkzeugs
- Platzieren der Kontaktvorrichtung an der Leiterplatte und
- Herstellen einer Lötverbindung zwischen der Leiterplatte und der Kontaktvorrichtung, insbesondere dem Befestigungsflansch der Kontaktvorrichtung.

Zur Herstellung einer Lötverbindung zwischen der Leiterplatte und der Kontaktvorrichtung dient vorzugsweise eine Lötpaste. Die Leiterplatte ist vorzugsweise ganz oder zumindest im Bereich der Kontaktvorrichtung als eine zur SMD-Bestückung geeignete Leiterplatte (SMD = Surface Mounted Device). Die Leiterplatte hat vorzugsweise im Bereich der Kontaktvorrichtung und/oder mit der Steckaufnahme der Kontaktvorrichtung fluchtend eine Durchtrittsöffnung zum Durchstecken des Steckkontakts.

Es ist ein Grundgedanke der vorliegenden Erfindung, dass die Kontaktvorrichtung einerseits eine Stützfläche zur flächigen Abstützung an der Leiterplatte hat, die beispielsweise zum Verlöten mit der Leiterplatte geeignet ist und somit auch einen großflächigen elektrischen Kontakt mit der Leiterplatte herstellen kann, andererseits an einer zu der Stützfläche entgegengesetzten Seite des Befestigungsflansches eine Ansaugfläche bereitstellt, die zum Ansaugen durch ein Bestückungswerkzeug, beispielsweise mit einem oder mehreren Saugrüsseln, einem Saugring oder dergleichen, geeignet ist. Somit kann das Bestückungswerkzeug die Kontaktvorrichtung ansaugen und auf der Leiterplatte platzieren, wo sie dann durch Verlöten, formschlüssige Verbindung oder dergleichen befestigt wird.

Zugleich ermöglicht die Kontaktvorrichtung eine gute Abstützung des Steckkontakts oder der Steckkontakte. Der Steckkontakt wird zwar vorzugsweise an einander entgegengesetzten Seiten durch die Kontaktzungen gehalten, aber auch in Winkelabständen dazu. Die Kontaktzungen erstrecken sich ringförmig um die Steckaufnahme herum oder begrenzen die Steckaufnahme, so dass der Stecckontakt winkelbeabstandet an mehreren Stellen durch die Kontaktzungen abgestützt ist.

Bevorzugt sind gleiche Winkelabstände, d.h. dass alle oder mehrere Kontaktzungen die gleichen Winkelabstände zueinander haben. Es ist aber auch möglich, dass unterschiedliche Winkelabstände zwischen mindestens zwei Paarungen jeweils nebeneinander angeordneter Kontaktzungen vorgesehen sind.

Die Winkelabstände betragen vorzugsweise maximal 90 Grad, insbesondere maximal 70 Grad oder sogar nur 60 Grad. Weiter bevorzugt ist es, wenn die Winkelabstände maximal 45 Grad, 40 Grad oder 30 Grad betragen. Wenn also in kleinen Winkelabständen jeweils Kontaktzungen an der Steckaufnahme angeordnet sind, wird der in die Steckaufnahme eingesteckte Steckkontakt möglichst optimal abgestützt.

Bevorzugt ist es, dass die Kontaktzungenanordnung mindestens zwei Kontaktzungen aufweist, die unmittelbar nebeneinander angeordnet sind. Ein Abstand zwischen den Kontaktzungen beträgt also weniger als die Winkelbreite oder Winkeldistanz einer anderen Kontaktzunge. Mithin passt also keine weitere oder gleichartige Kontaktzunge zwischen die beiden benachbarten Kontaktzungen.

Zwischen den Kontaktzungen sind vorzugsweise Abstände und/oder Aussparungen vorhanden.

Bevorzugt ist es weiterhin, wenn die Kontaktzungenanordnung mindestens zwei Kontaktzungen aufweist, die einander bezüglich der Steckaufnahme diagonal gegenüberliegen. Allerdings möglich ist es auch, dass die Kontaktzungen einander nicht diagonal unmittelbar einander gegenüberliegen, sondern mit einem Winkelversatz.

Weiterhin möglich ist es auch, dass zwischen zwei Kontaktzungen eine Lücke ist, die der Winkelbreite einer anderen Kontaktzunge entspricht.

Durch die geometrische Ausgestaltung der Kontaktzungen und/oder deren Anordnung um die Steckaufnahme herum können die elektrischen Kontakteigenschaften zur elektrischen Kontaktierung des Steckkontakts und/oder die mechanischen Eigenschaften zum Halten des Steckkontakts in der Steckaufnahme variiert werden.

Der elektrische Steckkontakt ist beispielsweise als ein Kontaktbolzen oder ein Kontaktpin, als massives Bauteil, als Hülsenbauteil oder dergleichen ausgestaltet. Der Steckkontakt wird von der Kontaktzungenanordnung an seinem Außenumfang mechanisch gehalten und in elektrischem Kontakt gehalten. Zudem ist eine thermische Energieübertragung zwischen dem Steckkontakt und den Kontaktzungen möglich.

Bevorzugt haben die Kontaktzungen ein mit dem Befestigungsflansch verbundenen, insbesondere mit dem Befestigungsflansch einstückigen, Basisbereich und in einem Längsabstand zu dem Basisbereich einen Kontaktbereich zur Anlage an dem Steckkontakt. Der Kontaktbereich ist vorzugsweise an den freien Längsendbereichen oder Endbereichen der Kontaktzungen vorgesehen. Es versteht sich aber, dass auch zwischen einem freien Endbereich und dem Basisbereich ein Kontaktbereich vorgesehen sein kann.

An dem Kontaktbereich ist vorzugsweise ein Kontaktvorsprung vorgesehen, der beispielsweise als Prägekontur ausgestaltet ist. Der Kontaktvorsprung steht in Richtung der Steckaufnahme und/oder in Richtung einer Kontaktstellung mit dem eingesteckten Steckkontakt vor eine Grundfläche des Kontaktbereichs vor. Der Kontaktvorsprung kann aber auch additiv auf das Material der Kontaktzunge aufgebracht sein. Der Kontaktvorsprung hat vorzugsweise eine kreisförmige Gestalt. Es ist aber auch möglich, dass der Kontaktvorsprung beispielsweise eine Längsgestalt aufweist. Insbesondere erstreckt sich die Längsgestalt eines derartigen Kontaktvorsprungs oder die Längsrichtung eines derartigen Kontaktvorsprungs parallel zur Steckachse, entlang derer der Steckkontakt in die Steckaufnahme eingesteckt ist oder einsteckbar ist.

Die Kontaktbereiche oder die freien Endbereiche der Kontaktzungen sind vorzugsweise schmaler als die Basisbereiche. Beispielsweise haben die Kontaktzungen eine etwa dreieckförmige Kontur oder eine trapezartige Kontur.

Die Basisbereiche stehen vorzugsweise in einem ersten Winkel von der Stützfläche ab und die Kontaktbereiche sind vorzugsweise winkelig zu den Basisbereichen. Die Kontaktbereiche weisen einen von dem ersten Winkel verschiedenen zweiten Winkel zu der Stützfläche auf. Mithin ist es also beispielsweise vorteilhaft, wenn der zweite Winkel in einer Kontaktstellung etwa ein rechter Winkel ist, wenn der Kontaktbereich einer Kontaktzunge an dem Steckkontakt anliegt. Somit ist beispielsweise der Kontaktbereich etwa parallel zur Außenumfangsfläche oder Außenoberfläche des Steckkontakts, wenn dieser in die Steckaufnahme eingesteckt ist.

Bevorzugt erstreckt sich ein erster Krümmungsabschnitt zwischen dem Befestigungsflansch und einem jeweiligen Kontaktvorsprung, wobei der Kontaktvorsprung bezüglich des ersten Krümmungsabschnitts vorteilhaft federnd nachgiebig an dem Befestigungsflansch gehalten ist, beispielsweise einstückig mit demselben ist. Der Krümmungsabschnitt ist z.B. als Biegeabschnitt ausgestaltet.

Zwischen dem Kontaktbereich und dem Basisbereich einer Kontaktzunge ist zweckmäßigerweise ein zweiter Krümmungsabschnitt vorgesehen, wobei der Kontaktbereich bezüglich des Basisbereichs entlang des Krümmungsabschnitts vorteilhaft federnd nachgiebig ist. Der zweite Krümmungsabschnitt ermöglicht jedenfalls die Herstellung des vorgenannten zweiten Winkels oder stellt den zweiten Winkel bereit.

An dieser Stelle sei nachgetragen, dass die federnde Nachgiebigkeit entlang der vorgenannten Krümmungsabschnitte eine vorteilhafte Option darstellt. Es ist auch möglich, dass an einem oder beiden der Krümmungsabschnitte keine federnde Nachgiebigkeit vorgesehen ist.

Ohne weiteres können weitere Krümmungsabschnitte oder Biegeabschnitte zwischen dem Basisbereich und dem freien Endbereich einer Kontaktzunge vorgesehen sein. Es ist zum Beispiel auch möglich, dass ein freier Endbereich einer Kontaktzunge in einem Sinne von der Steckaufnahme weg geneigt oder gebogen ist, was beispielsweise ein Einstecken eines Steckkontakt von dem freien Endbereich der Kontaktzunge her in die Steckaufnahme erleichtert und/oder eine Einführschräge bereitstellt.

Die Stützfläche und/oder die Ansaugfläche und/oder die Steckaufnahme sind vorzugsweise ringförmig. Insbesondere sind die Stützfläche oder die Ansaugfläche oder beide vorzugsweise kreisringförmig. Andere Geometrien, beispielsweise rechteckförmige oder quadratische, dreieckförmige oder sonstige polygonale Querschnittsgeometrien der Stützfläche und/oder Ansaugfläche und/oder der Steckaufnahme sind ohne weiteres möglich.

Vorteilhaft sind die Stützfläche und die Ansaugfläche und/oder der Befestigungsflansch in Bezug auf die Steckaufnahme geschlossen ringförmig. Es ist möglich, dass die Stützfläche oder die Ansaugfläche bezüglich der Steckaufnahme nicht geschlossen sind, d.h. dass beispielsweise ein radialer Schlitz die Stützfläche oder Ansaugfläche oder beide oder den Befestigungsflansch durchsetzt. Mithin kann also der Befestigungsflansch eines oder mehrere Winkelsegmente umfassen. Diese Winkelsegmente erstrecken sich jedoch vorzugsweise über einen Winkelbereich von mindestens 90 Grad, vorzugsweise mindestens 180 Grad, insbesondere mindestens 270 Grad.

Der Befestigungsflansch weist beispielsweise eine durch die Stützfläche gebildete Lötfläche zum Verlöten mit der Leiterplatte auf. Es ist möglich, dass der Befestigungsflansch als Ganzes als lötbares Bauteil ausgestaltet ist.

Die Kontaktzungen sind vorzugsweise in der Art einer Rosette um die Steckaufnahme angeordnet.

Bevorzugt bilden die Kontaktzungen einen Aufnahmedom, in den der Steckkontakt einsteckbar ist und/oder der durch den Steckkontakt aufweitbar ist.

An dem Befestigungsflansch ist vorzugsweise eine Verankerungsfußanordnung mit mindestens einem Verankerungsfuß angeordnet, der von der Stützfläche zum Eindringen in eine Verankerungsaufnahme der Leiterplatte winkelig, beispielsweise rechtwinkelig, absteht. Der mindestens eine Verankerungsfuß hat also beispielsweise eine Längsachse, die winkelig, insbesondere rechtwinkelig, zu der Stützfläche ist. Der Verankerungsfuß steht von der Stützfläche winkelig ab.

Bevorzugt ist es, wenn die Kontaktzungen und der mindestens eine Verankerungsfuß oder alle Verankerungsfüße der Verankerungsfußanordnung zu einander entgegengesetzten Seiten von dem Befestigungsflansch abstehen. Es ist aber auch möglich, dass die Kontaktzungen zur selben Seite wie der mindestens eine Verankerungsfuß oder die Verankerungsfüße von dem Befestigungsflansch abstehen, also beispielsweise vor die Stützfläche vorstehen. Derartige Kontaktzungen können beispielsweise in eine Durchtrittsöffnung der Leiterplatte vorstehen. Bevorzugt hat die Verankerungsfußanordnung an einander entgegengesetzten Seiten bezüglich der Steckaufnahme an dem Befestigungsflansch angeordnete Verankerungsfüße.

Die Verankerungsfußanordnung umfasst vorzugsweise mindestens zwei, insbesondere vorteilhaft mindestens drei, weiter bevorzugt mindestens vier Verankerungsfüße, die in einem Winkelabstand zueinander angeordnet sind. Die Winkelabstände können gleich oder verschieden sein.

Weiterhin vorteilhaft ist es, wenn der mindestens eine Verankerungsfuß, vorteilhaft alle Verankerungsfüße, radial außen bezüglich der Steckaufnahme an dem Befestigungsflansch angeordnet ist. Es ist aber auch möglich, dass ein Verankerungsfuß zwischen dem Innenumfang und dem Außenumfang des Befestigungsflansches vor seine Stützfläche vorstehen.

Am Außenumfang des Befestigungsflansches können Vorsprünge vorgesehen sein, beispielsweise Vorsprünge zur Vergrößerung der Ansaugfläche oder der Stützfläche oder beiden.

Vorzugsweise ist mindestens ein Verankerungsfuß unmittelbar neben einer Stützfläche angeordnet und/oder verläuft tangential neben einer Stützfläche.

Weiterhin ist der mindestens eine Verankerungsfuß vorteilhaft einstückig mit dem Befestigungsflansch.

Der mindestens eine Verankerungsfuß, vorzugsweise mehrere oder alle Verankerungsfüße, weist vorteilhaft einen Fußabschnitt auf, der sich tangential vom Außenumfang des Befestigungsflansches weg erstreckt.

Vorteilhaft ist weiterhin, wenn eine Verankerungsaufnahme, in die der Verankerungsfuß eindringt, eine für Lötmaterial bindungsfähige Oberfläche aufweist, beispielsweise eine metallische Beschichtung.

Vorteilhaft ist es, wenn die Verankerungsaufnahme mit pastösem Lötmaterial verfüllt ist und anschließend der Verankerungsfuß in die Verankerungsaufnahme eingedrückt wird, bevor das Lötmaterial zur Herstellung der Lötverbindung zwischen der Verankerungsaufnahme und dem Verankerungsfuß erhitzt wird. Mithin wird also sozusagen ein Depot oder Lötdepot gebildet, in welches der Verankerungsfuß eindringt.

Insgesamt ist es vorteilhaft, wenn bei dem erfindungsgemäßen Verfahren zunächst die Leiterplatte mit pastösen Lötmaterial bedruckt wird und anschließend mindestens eine erfindungsgemäße Kontaktvorrichtung, vorzugsweise alle erfindungsgemäßen Kontaktvorrichtungen sowie optionale weitere mit der Leiterplatte zu verlötende Bauteile an der Leiterplatte angeordnet werden.

Der Befestigungsflansch weist vorteilhaft mindestens einen nach radial außen bezüglich der Steckaufnahme und/oder der zum Einstecken des Steckkontakts in die Kontaktvorrichtung vorgesehenen Steckachse vorstehenden Vorsprung oder Vorsprungabschnitt auf, über den sich die Stützfläche und/oder die Ansaugfläche erstrecken.

Die Kontaktvorrichtung ist vorzugsweise als Stanz-Biegeteil ausgestaltet. Vorteilhaft ist ein Rohling der Kontaktvorrichtung aus einem Bandmaterial oder Plattenmaterial ausgeschnitten, insbesondere ausgestanzt. Die Verankerungsfüße und/oder Kontaktzungen sind vorzugsweise durch ein Biegewerkzeug hergestellt.

Aussparungen zur Herstellung von Abständen zwischen den Kontaktzungen können beispielsweise anhand eines Schneidwerkzeugs oder Stanzwerkzeugs aus dem Rohling hergestellt werden.

Das Material der Kontaktvorrichtung ist vorzugsweise ein metallisches Material. Vorteilhaft ist es, wenn die Kontaktvorrichtung ganz oder zumindest teilweise aus Beryllium-Kupfer oder Beryllium-Bronze besteht. Beispielsweise besteht ein Grundkörper der Kontaktvorrichtung aus einem derartigen Material.

Die Kontaktvorrichtung oder deren Grundkörper können auch ganz oder teilweise mit einer Beschichtung versehen sein, beispielsweise mit einer Beschichtung aus Silber. Eine derartige Beschichtung hat beispielsweise eine Dicke von einem bis 4 µm, vorzugsweise ungefähr 2 µm. Es sind auch mehrere Schichten möglich, beispielsweise unter der Silberbeschichtung eine Nickel-Beschichtung.

Vorteilhaft ist es, wenn sämtliche Komponenten oder Abschnitte der Kontaktvorrichtung einstückig miteinander sind.

Das Grundmaterial der Kontaktvorrichtung ist vorzugsweise ein Blechmaterial

Nachfolgend wird ein Ausführungsbeispiel der Erfindung anhand der Zeichnung erläutert. Es zeigen:

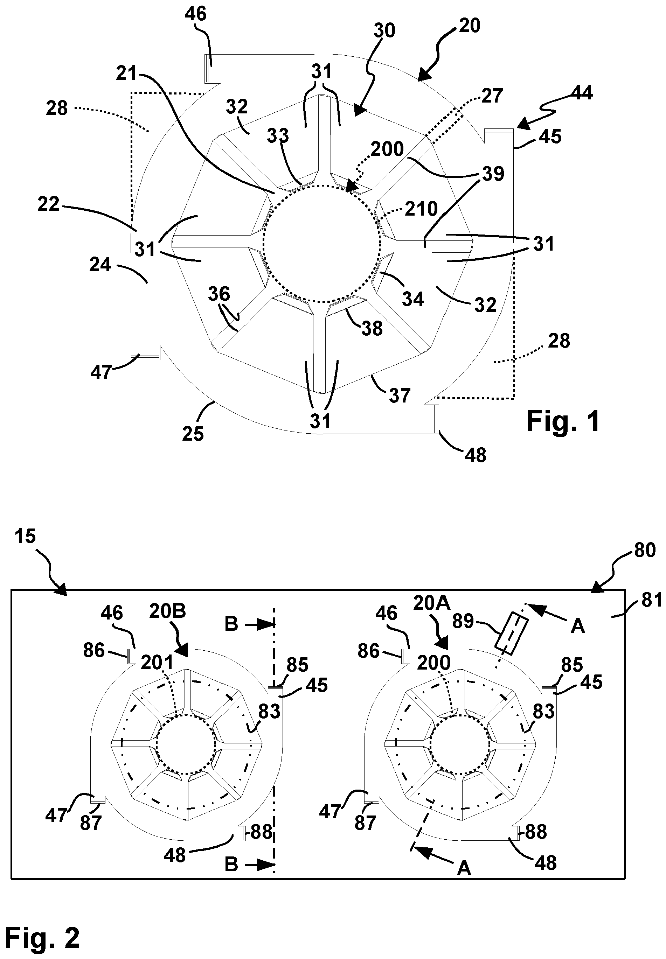

- Figur 1: eine Draufsicht auf eine elektrische Kontaktvorrichtung gemäß der Erfindung,
- Figur 2: eine Leiterplatte mit zwei Kontaktvorrichtungen gemäß der Erfindung von oben,
- Figur 3: ein Rohling der Kontaktvorrichtung in einem aus einem Plattenmaterial ausgeschnittenen Zustand,
- Figur 4: eine Draufsicht auf eine Bahn mit mehreren ausgestanzten oder zum Ausstanzen anstehenden Rohlingen der Kontaktvorrichtung,
- Figur 5: eine Querschnittsdarstellung einer Kontaktvorrichtung, etwa entlang einer Schnittlinie A-A in Figur 2,
- Figur 6: eine Ansicht ähnlich wie Figur 5, jedoch mit eingestecktem Stecckontakt, und
- Figur 7: einen weiteren Querschnitt durch einen Verankerungsfuß der Kontaktvorrichtung gemäß vorstehender Figuren, etwa entlang einer Schnittlinie B-B in Figur 2.

Eine Kontaktvorrichtung 20 weist eine Steckaufnahme 21 zum Einstecken eines Steckkontaktes 200 oder 201 auf. Beispielsweise sind an einer Leiterplatte 80 zwei Kontaktvorrichtungen 20, die als Kontaktvorrichtungen 20A, 20B bezeichnet sind, angeordnet, in die die Steckkontakte 200 und 201 eingesteckt oder einsteckbar sind. Die Leiterplatte 80 bildet vorteilhaft einen Bestandteil einer elektrischen Vorrichtung 15, zum Beispiel einer Batterie-Anschlusseinrichtung, einer Ladeeinrichtung zum elektrischen Aufladen von elektrischen Batterien, Akkumulatoren oder dergleichen andere Vorrichtung. Auf die konkrete Ausgestaltung der Vorrichtung 15 kommt es jedoch nicht an.

Jede Kontaktvorrichtung 20 weist einen Befestigungsflansch 22 mit einer Stützfläche 23 und einer dieser entgegengesetzten Ansaugfläche 24 auf. Die Stützfläche ist flächig, insbesondere vollflächig, auf einer ersten Seite oder Bestückungsseite, nachfolgend als Vorderseite 81 bezeichneten Seite, der Leiterplatte 80 abgestützt. Beispielsweise stützt sich eine Stützfläche 23 des Befestigungsflansches 22 im Bereich einer elektrisch leitfähigen Schicht 91 der Leiterplatte 80 ab und ist mit dieser Schicht 91 verlötet. Exemplarisch ist Lötmaterial 90, welches die Stützfläche 23 mit der Schicht 91 verbindet, in der Zeichnung angedeutet.

Der Befestigungsflansch 22 weist an einander entgegengesetzten Seiten einerseits die Stützfläche 23 und andererseits eine Ansaugfläche 24 auf. Die Ansaugfläche 24 dient zum Ansaugen durch ein Bestückungswerkzeug 300. Von dem Bestückungswerkzeug 300 sind Ansaugpipetten oder Ansaugkanäle 301, 302 schematisch angedeutet, deren freie Enden Ansaugöffnungen aufweisen, mit denen die Ansaugfläche 24 und somit die Kontaktvorrichtung 20 als Ganzes ansaugbar ist. Beispielsweise stehen die Kontaktvorrichtungen 20 in Blisterverpackungen und/oder auf einem Gurtmaterial bereit und werden vom Bestückungswerkzeug 300 davon entnommen.

Im Rahmen eines Pick-and-Place-Prozesses wird also eine jeweilige Kontaktvorrichtung 20 durch das Bestückungswerkzeug 300 auf die Vorderseite 81 der Leiterplatte 80 aufgesetzt und anschließend anhand des Lötmaterials 90 verlötet.

Bei diesem Lötprozess können auch weitere Bauteile auf der Leiterplatte 80 elektrisch kontaktierend verlötet werden, beispielsweise ein exemplarisch dargestelltes elektrisches oder elektronisches Bauteil 89, zum Beispiel ein Halbleiter-Chip. Ohne weiteres sind weitere elektrische Bauteile 89 an der Leiterplatte 80 befestigbar oder befestigt.

Ferner sind an dem Befestigungsflansch 22 Verankerungsfüße 45, 46, 47 und 48 angeordnet, die vor die Stützfläche 23 winkelig vorstehen, beispielsweise rechtwinkelig. Die Verankerungsfüße 45-48 sind am Außenumfang 25 des Befestigungsflansches 22 bzw. der Kontaktvorrichtung 20 angeordnet. Vorteilhaft sind mindestens zwei aneinander entgegengesetzten oder einander gegenüberliegenden Seiten des Befestigungsflansches Verankerungsfüße vorgesehen, beispielsweise die Verankerungsfüße 45 und 47 oder 46 und 48. Im vorliegenden Fall sind insgesamt vier Verankerungsfüße 45-48 vorgesehen (weitere Verankerungsfüße oder auch weniger Verankerungsfüße sind ohne weiteres möglich), so dass in unterschiedlichen oder vorteilhaft gleichen Winkelabständen jeweils ein Verankerungsfuß 45-48 an dem Befestigungsflansch 22 vorgesehen ist.

Die Verankerungsfüße 45-48 dringen in Verankerungsaufnahmen 85, 86, 87 und 88 der Leiterplatte 80 ein, die beispielsweise als Bohrungen ausgestaltet sind.

Nun wäre es eine Möglichkeit, dass die Verankerungsfüße 45-48 formschlüssig und/oder im Klemmsitz in den Verankerungsaufnahmen 85-88 gehalten werden, wofür beispielswiese ein Einpresswerkzeug vorgesehen sein kann, welches in der Art des Bestückungswerkzeuges 300 auf die Stützfläche 23 im Bereich der Verankerungsfüße 45-48 einwirkt.

Des Weiteren wäre es auch möglich, dass beispielsweise die freien Endbereiche 49 der Verankerungsfüße 45-48 Hakenabschnitte 50 aufweisen, mit denen die Verankerungsfüße 45-48 an einer zur ersten Seite oder Vorderseite 81 entgegengesetzten zweiten Seite oder Rückseite 82 der Leiterplatte 80 abgestützt sind. Die Hakenabschnitte 50 verlaufen beispielsweise im Wesentlichen parallel zur Stützfläche 23.

Beide vorgenannten Maßnahmen zur Befestigung der Verankerung Füße 45-48 an der Leiterplatte 80 können auch gleichzeitig vorgesehen sein oder auch in Verbindung mit der nachfolgend erläuterten Maßnahme:
Bevorzugt ist eine Lötverbindung derart, dass die Stützfüße oder Verankerungsfüße 45-48 anhand von Lötmaterial 90 an der Schicht 91 und zudem auch im Bereich der Verankerungsaufnahmen 85-88 gehalten ist. Selbst wenn dort keine mit dem Lötmaterial 90 bindungsfähige Oberfläche der Leiterplatte 80 vorhanden ist, zum Beispiel eine metallische Oberfläche ergibt sich ein formschlüssiger Halt, da das Lötmaterial 90 im Bereich der Verankerungsaufnahme 85-88 aushärtet. Vorzugsweise ist jedoch eine metallische oder anderweitige mit Lötmaterial bindungsfähige Beschichtung am Innenumfang der Verankerungsaufnahmen 85-88 vorgesehen.

Somit dienen die Verankerungsfüße 45-48 im Wesentlichen dazu, die Kontaktvorrichtung 20 in Bezug auf Scherkräfte SK oder Scherkraftkomponenten abzustützen, die parallel zu der Stützfläche 23 verlaufen, also beispielsweise parallel zu den Flachseiten der Leiterplatte 80, insbesondere der Vorderseite 81.

Die Lötverbindung oder das Lötmaterial 90 zwischen der leitfähigen Schicht 91 und der Stützfläche 23 hingegen sorgen für eine Zugfestigkeit in Bezug auf Zugkräfte ZK, die eine zur Stützfläche 23 senkrechte Kraftkomponente enthalten oder dadurch gebildet sind.

Die geschilderte feste Verankerung der Kontaktvorrichtungen 20 an der Leiterplatte 80 ist sowohl beim Einstecken der Steckkontakte 200, 201 entlang einer Steckachse S in einer Steckrichtung SR vorteilhaft, als auch bei der späteren Nutzung der Leiterplatte 80 mit den eingesteckten Steckkontakten 200, 201 oder weiteren, in der Zeichnung nicht dargestellten Steckkontakten und Kontaktvorrichtungen.

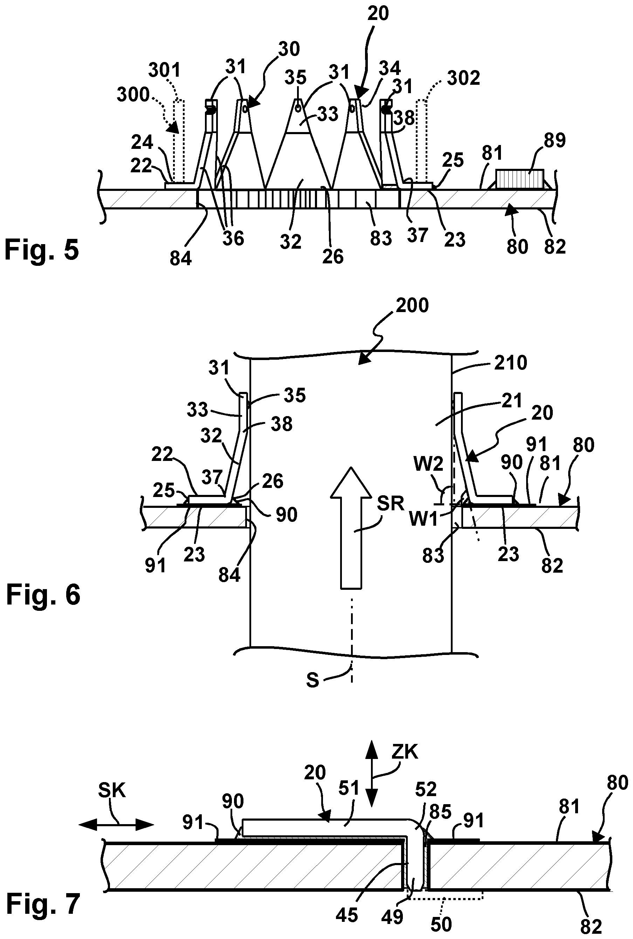

Die Leiterplatte 80 weist zum Durchstecken der Steckkontakte 200, 201 Durchtrittsöffnungen 83 auf. Die Durchtrittsöffnungen 83 weisen einen derartigen Durchmesser auf, dass die Steckkontakte 200, 201 mit radialem Spiel bezüglich der Steckachse S die Durchtrittsöffnungen 83 durchdringen, so dass sie durch eine Kontaktzungenanordnung 30 der Kontaktvorrichtung 20 in elektrischen Kontakt gehalten werden können. Zwischen dem Außenumfang 210 eines jeweiligen Steckkontaktes 200, 201 und einer Innenumfangsfläche 84 einer Durchtrittsöffnung 83 ist also ein Bewegungsspiel möglich, siehe dazu beispielsweise Figur 6.

Die Anordnung der Verankerungsaufnahme 85-88 relativ zur Durchtrittsöffnung 83 und die Ausgestaltung der Verankerungsfüße 45-48 ermöglicht eine präzise Anordnung der Kontaktvorrichtungen 20 an der Leiterplatte 80. Allerdings ist es durchaus möglich, dass die Steckkontakte 200, 201 sowie weitere, in der Zeichnung nicht dargestellte, Steckkontakte, quer zu ihrer jeweiligen Längserstreckung, also beispielsweise quer zur Steckachse S, unterschiedliche Abstände aufweisen. Derartige Toleranzen werden durch die Kontaktzungenanordnung 30 ausgeglichen.

Ein Innenumfang 26 des Befestigungsflansches 22 weist vorteilhaft einen größeren Durchmesser als die Innenumfangsfläche 84 auf. Mithin stehen also Kontaktzungen 31 der Kontaktzungenanordnung 30 von radial außen in Richtung der Durchtrittsöffnung 83 vor.

Der Befestigungsflansch 22 ist ringförmig. Bevorzugt ist der Befestigungsflansch 22 plattenartig. Der Befestigungsflansch 22 ist vorliegend kreisringförmig, wobei selbstverständlich auch andere Außenumfangsgeometrien möglich sind. Prinzipiell denkbar ist auch, dass der Befestigungsflansch 22 mindestens eine Unterbrechung 27 aufweist, beispielsweise einen sich vom Innenumfang 26 zum Außenumfang 25 erstreckenden Schlitz oder dergleichen andere Unterbrechung.

Des Weiteren ist es möglich, dass der Befestigungsflansch 22 eine im Wesentlichen ringförmige Gestalt aufweist, d.h., dass beispielsweise der Abstand zwischen seinem Außenumfang 25 und seinem Innenumfang 26 im Wesentlichen gleich ist.

Vor den Außenumfang 25 können aber auch Vorsprünge 28 vorstehen, mit denen die Ansaugfläche 24 und/oder die Stützfläche 23 vergrößert oder vergrößerbar ist. Die Vorsprünge 28 eignen sich insbesondere zum Ansaugen durch das Bestückungswerkzeug 300. Zudem vergrößern sie vorteilhaft die Stützfläche 23 und somit eine zum Verlöten mit dem Lötmaterial 90 geeignete Oberfläche der Kontaktvorrichtung 20.

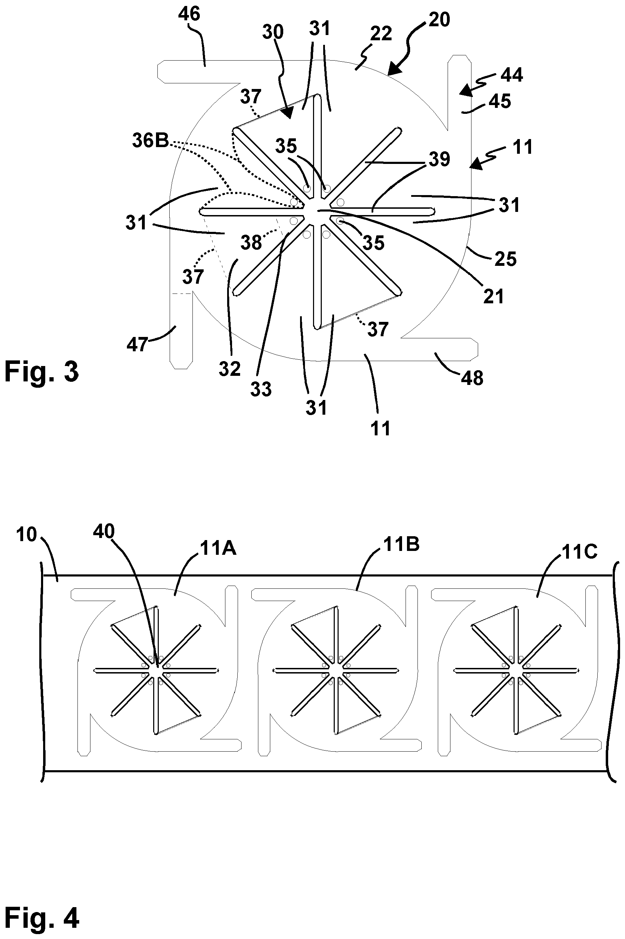

Die Kontaktzungen 31 sind einstückig mit dem Befestigungsflansch 22. Ebenso sind auch die Verankerungsfüße 45-48 einstückig mit dem Befestigungsflansch 22. Sie sind beispielsweise aus einem metallischen Bahnmaterial ausgeschnitten oder ausgestanzt, beispielsweise durch eine in der Zeichnung nicht dargestelltes Schneidwerkzeug oder Stanzwerkzeug. Ein derartiges Stanzwerkzeug hat beispielsweise Schneidkanten in Figur 3 durchgezogenen Randlinien oder Randbereichen des Rohlings 11. Beispielsweise wäre Laserschneiden, Stanzen oder dergleichen eine geeignete Möglichkeit, aus dem Bahnmaterial 10 Rohlinge 11 auszustanzen, beispielsweise Rohlinge 11A, 11 B, 11C.

Die Verankerungsfüße 45 weisen Fußabschnitte 51 auf, die sich tangential von dem Befestigungsflansch 22 weg erstrecken. Zwischen dem Fußabschnitt 51 und dem freien Ende 49 eines Verankerungsfußes 45 erstreckt sich ein Krümmungsabschnitt 52.

Die Verankerungsfüße 45 sind vorteilhaft durch mindestens ein Biegewerkzeug hergestellt, mit welchem der Rohling 11 bearbeitet ist.

Mit einem derartigen Biegewerkzeug oder einer Biegewerkzeuganordnung lassen sich auch die Kontaktzungen 31 ohne weiteres herstellen.

Die Kontaktzungen 31 weisen einen Basisbereich 32 auf, der einstückig mit dem Befestigungsflansch 22 ist. Zwischen dem Basisbereich 32 und dem Befestigungsflansch 22 erstreckt sich ein Krümmungsabschnitt 37, also ein erster Krümmungsabschnitt. Somit stehen die Basisbereiche 32 in einem ersten Winkel W1 von dem Befestigungsflansch 22 ab. Der Winkel W1 beträgt beispielsweise etwa 60-80°. Der Winkel W1 könnte aber auch beispielsweise 90° betragen, sodass die nachfolgend erläuterte vorteilhafte Maßnahme dann nicht notwendig wäre, durch die sich ergibt, dass die Kontaktbereiche 33 etwa parallel zur Steckachse S verlaufen.

Zwischen dem Basisbereich 32 und einem Kontaktbereich 33 einer Kontaktzunge 31 ist ein weiterer, zweiter Krümmungsabschnitt 38 vorgesehen. Mithin sind also die Kontaktbereiche 33 winkelig zu den Basisbereichen 32. Die Kontaktbereiche 33 weisen beispielsweise einen Winkel W2 bezüglich des Befestigungsflansches 22 und/oder der Stützfläche 23 auf. Der Winkel W2 beträgt vorzugsweise etwa 90°. Vorteilhaft ergibt sich dadurch, dass der Kontaktbereich 33 etwa parallel zur Steckachse S verläuft, so dass ein optimaler Kontakt der Kontaktzunge 31 mit dem Steckkontakt 200, 201 herstellbar ist.

Vorteilhaft ist es, wenn an den Kontaktbereichen 33 Kontaktvorsprünge 35, beispielsweise punktförmige, insbesondere durch Prägungen hergestellte Kontaktvorsprünge, vorgesehen sind, die in Richtung der Steckaufnahme 21 oder deren Zentrum vorstehen. Die Kontaktvorsprünge 35 können auch eine langgestreckte, sich parallel zur Steckachse S erstreckende Gestalt oder auch andere Geometrien aufweisen.

Durch das vorgenannte Stanzwerkzeug können beispielsweise Aussparungen 39 zwischen den Kontaktzungen 31 aus dem Rohling 11 ausgestanzt werden. Die Aussparungen 39 ermöglichen beispielsweise ein leichteres Bewegungsspiel zwischen den einzelnen Kontaktzungen 31, die ansonsten jedoch unmittelbar nebeneinander angeordnet sind. Somit haben jedenfalls Seitenflanken oder Schmalseiten 36 der Kontaktzungen 31 einen Winkelabstand zueinander. An dieser Stelle sei erwähnt, dass beispielsweise zur Einstellung unterschiedlich großer Federkräfte andere Verläufe der Schmalseiten 36 möglich sind. Beispielsweise können sich die freien Endbereiche 34 stärker bezüglich der Basisbereiche 32 verjüngen, was durch Schmalseiten 36B in Figur 3 angedeutet ist.

Vorteilhaft ist es, wenn die Kontaktzungen einer erfindungsgemäßen Kontaktvorrichtung derart aus einem Rohling ausgestanzt oder ausgebildet sind, dass sie aus einem in die Steckaufnahme der Kontaktvorrichtung vorstehenden Material des Rohlings gebildet sind, was beispielsweise auch bei der Kontaktvorrichtung 20 realisiert ist. Zwar wäre es grundsätzlich möglich, dass das Material derart ausgeschnitten ist, dass die freien Endbereiche 34 einander gegenüberliegender Kontaktzungen 31 unmittelbar aneinander anstoßen, wenn der Rohling 11 noch nicht in die gebrauchsfertige Form der Kontaktvorrichtung 20 gebogen oder verformt ist, bei der die Kontaktzungen 31 und/oder die Verankerungsfüße 45-48 vor den Befestigungsflansch 22 vorstehen. Vorteilhaft ist es jedoch, wenn beispielsweise zwischen den freien Endbereichen 34 der Kontaktzungen 31 eine Aussparung 40, insbesondere eine im wesentlichen kreisrunde Aussparung, schon beim Rohling 11, jedenfalls bei der geformten oder gebrauchsfertigen Kontaktvorrichtung 20 vorhanden ist.

## Patentansprüche

1. Elektrische Kontaktvorrichtung zur Herstellung einer elektrischen Verbindung zwischen einem Steckkontakt (200) und einer Leiterplatte (80), wobei die Kontaktvorrichtung (20) eine Steckaufnahme (21) zum Einstecken des Steckkontakts (200) und einen Befestigungsflansch (22) zur Befestigung der Kontaktvorrichtung (20) an der Leiterplatte (80) aufweist, wobei sich der Befestigungsflansch (22) ringförmig um die Steckaufnahme (21) erstreckt und an einander entgegengesetzten Seiten eine Stützfläche (23) zur flächigen Abstützung an der Leiterplatte (80) und eine Ansaugfläche (24) zum Ansaugen durch ein Bestückungswerkzeug (300) aufweist, das zum Bestücken der Leiterplatte (80) mit der Kontaktvorrichtung (20) vorgesehen ist, wobei die Kontaktvorrichtung (20) eine Kontaktzungenanordnung (30) mit federnd nachgiebigen Kontaktzungen (31) aufweist, die winkelig zu der Stützfläche (23) in Richtung der Steckaufnahme (21) zur Anlage an dem Steckkontakt (200) vorstehen, wobei die Kontaktzungen (31) in Winkelabständen zueinander rings um die Steckaufnahme (21) angeordnet sind.

2. Kontaktvorrichtung (20) nach Anspruch 1, **dadurch gekennzeichnet, dass** die Winkelabstände maximal 90°, vorzugsweise maximal 70°, insbesondere maximal 60°, weiter bevorzugt maximal 45° oder 40°, betragen und/oder dass die Kontaktzungenanordnung (30) mindestens zwei Kontaktzungen (31) aufweist, die unmittelbar nebeneinander angeordnet sind.

3. Kontaktvorrichtung (20) nach Anspruch 1 oder 2, **dadurch gekennzeichnet, dass** die Kontaktzungenanordnung (30) mindestens zwei Kontaktzungen (31) aufweist, die einander bezüglich der Steckaufnahme (21) diagonal gegenüberliegen, und/oder dass die Kontaktzungen (31) einen mit dem Befestigungsflansch (22) verbundenen, insbesondere einstückigen, Basisbereich (32) aufweisen und in einem Längsabstand zu dem Basisbereich (32), insbesondere an ihren freien Endbereichen (34), einen Kontaktbereich (33) zur Anlage an dem Steckkontakt (200) aufweisen.

4. Kontaktvorrichtung (20) nach einem der vorhergehenden Ansprüche, **dadurch gekennzeichnet, dass** an dem Kontaktbereich (33) ein insbesondere als Prägekontur ausgestalteter Kontaktvorsprung (35) vorgesehen ist und/oder dass die Kontaktbereiche (33) und/oder die freien Endbereiche (34) der Kontaktzungen (31) schmaler als die Basisbereiche (32) sind.

5. Kontaktvorrichtung (20) nach einem der vorhergehenden Ansprüche, **dadurch gekennzeichnet, dass** die Basisbereiche (32) in einem ersten Winkel (W1) von der Stützfläche (23) abstehen und die Kontaktbereiche (33) winkelig zu den Basisbereichen (32) sind, wobei die Kontaktbereiche (33) einen von dem ersten Winkel (W1) verschiedenen zweiten Winkel (W2) zu der Stützfläche (23) aufweisen, wobei vorteilhaft vorgesehen ist, dass der zweite Winkel (W2) in einer Kontaktstellung etwa ein rechter Winkel ist, wenn der Kontaktbereich (33) einer Kontaktzunge (31) an dem Steckkontakt (200) anliegt.

6. Kontaktvorrichtung (20) nach einem der vorhergehenden Ansprüche, **dadurch gekennzeichnet, dass** sich ein erster Krümmungsabschnitt (37) zwischen dem Befestigungsflansch (22) und einem jeweiligen Kontaktvorsprung (35) erstreckt, wobei der Kontaktvorsprung (35) bezüglich des ersten Krümmungsabschnitts (37) vorteilhaft federnd nachgiebig an dem Befestigungsflansch (22) gehalten ist, und/oder dass zwischen dem Kontaktbereich (33) und dem Basisbereich (32) einer Kontaktzunge (31) ein zweiter Krümmungsabschnitt (38) vorgesehen ist, wobei der Kontaktbereich (33) bezüglich des Basisbereiche (32) vorteilhaft entlang des zweiten Krümmungsabschnitts (38) federnd nachgiebig ist.

7. Kontaktvorrichtung (20) nach einem der vorhergehenden Ansprüche, **dadurch gekennzeichnet, dass** die Stützfläche (23) und/oder die Ansaugfläche (24) ringförmig sind und/oder sich, insbesondere geschlossen, um den gesamten Außenumfang der Steckaufnahme (21) und/oder der Kontaktzungenanordnung (30) herum erstrecken.

8. Kontaktvorrichtung (20) nach einem der vorhergehenden Ansprüche, **dadurch gekennzeichnet, dass** der Befestigungsflansch (22) eine insbesondere durch die Stützfläche (23) gebildete Lötfläche zum Verlöten mit der Leiterplatte (80) aufweist.

9. Kontaktvorrichtung (20) nach einem der vorhergehenden Ansprüche, **dadurch gekennzeichnet, dass** die Kontaktzungen (31) in der Art einer Rosette um die Steckaufnahme (21) angeordnet sind und/oder dass die Kontaktzungen (31) einen, insbesondere durch den Steckkontakt (200) aufweitbaren, Aufnahmedom für den Steckkontakt (200) bilden.

10. Kontaktvorrichtung (20) nach einem der vorhergehenden Ansprüche, **dadurch gekennzeichnet, dass** an dem Befestigungsflansch (22) eine Verankerungsfußanordnung (44) mit mindestens einem Verankerungsfuß (45) angeordnet ist, der von dem Befestigungsflansch (22) zum Eindringen in eine Verankerungsaufnahme (85) der Leiterplatte (80), insbesondere bezüglich der Stützfläche (23), winkelig, insbesondere rechtwinkelig, absteht.

11. Kontaktvorrichtung (20) nach Anspruch 10, **dadurch gekennzeichnet, dass** die Kontaktzungen (31) und der mindestens eine Verankerungsfuß (45) zu einander entgegengesetzten Seiten von dem Befestigungsflansch (22) abstehen und/oder der mindestens eine Verankerungsfuß (45) eine Lötfläche zum Verlöten mit der Leiterplatte (80) aufweist und/oder dass die Verankerungsfußanordnung (44) mindestens zwei, vorzugsweise mindestens drei, insbesondere mindestens vier Verankerungsfüße (45) aufweist, die in einem Winkelabstand zueinander angeordnet sind und/oder an einander entgegengesetzten Seiten bezüglich der Steckaufnahme (21) an dem Befestigungsflansch (22) angeordnet sind, und/oder dass der mindestens eine Verankerungsfuß (45) radial außen bezüglich der Steckaufnahme (21) an dem Befestigungsflansch (22) angeordnet ist und/oder einen Fußabschnitt aufweist, der tangential vor einen Außenumfang (25) des Befestigungsflansches (22) vorsteht.

12. Kontaktvorrichtung (20) nach einem der vorhergehenden Ansprüche, **dadurch gekennzeichnet, dass** sie ein Stanz-Biegeteil ist und/oder aus einem Rohling (11) geformt ist, der aus einem Blechkörper oder Plattenmaterial oder Bahnmaterial ausgeschnitten oder ausgestanzt ist und/oder dass die Kontaktzungen (31) aus einem von dem Befestigungsflansch (22) sich in den Innenraum der Steckaufnahme (21) erstreckenden Grundmaterial der Kontaktvorrichtung (20) gebildet ist.

13. Kontaktvorrichtung (20) nach einem der vorhergehenden Ansprüche, **dadurch gekennzeichnet, dass** der Außenumfang (25) des Befestigungsflansches (22) mindestens einen Vorsprung (28), insbesondere zur Vergrößerung der Ansaugfläche (24) und/oder der Stützfläche (23), aufweist, wobei vorteilhaft vorgesehen ist, dass mindestens ein Verankerungsfuß (45) unmittelbar neben dem mindestens einen Vorsprung (28) angeordnet ist und/oder sich parallel zu dem Vorsprung (28) erstreckt.

14. Elektrische Leiterplatte (80) mit einer Kontaktvorrichtung (20) nach einem der vorhergehenden Ansprüche, wobei die Leiterplatte (80) vorteilhaft eine mit der Steckaufnahme (21) fluchtende Durchtrittsöffnung (83) für den Steckkontakt (200) aufweist.

15. Verfahren zur Herstellung einer elektrischen Vorrichtung (15) umfassend eine Leiterplatte (80) und mindestens eine Kontaktvorrichtung (20) zur Herstellung einer elektrischen Verbindung zwischen einem Steckkontakt (200) und der Leiterplatte (80), wobei die Kontaktvorrichtung (20) eine Steckaufnahme (21) zum Einstecken des Steckkontakts (200) und einen Befestigungsflansch (22) zur Befestigung der Kontaktvorrichtung (20) an der Leiterplatte (80) aufweist, wobei sich der Befestigungsflansch (22) ringförmig um die Steckaufnahme (21) erstreckt und an einander entgegengesetzten Seiten eine Stützfläche (23) zur flächigen Abstützung an der Leiterplatte (80) und eine Ansaugfläche (24) zum Ansaugen durch ein Bestückungswerkzeug (300) aufweist, das zum Bestücken der Leiterplatte (80) mit der Kontaktvorrichtung (20) vorgesehen ist, wobei die Kontaktvorrichtung (20) eine Kontaktzungenanordnung (30) mit federnd nachgiebigen Kontaktzungen (31) aufweist, die winkelig zu der Stützfläche (23) in Richtung der Steckaufnahme (21) zur Anlage an dem Steckkontakt (200) vorstehen, wobei die Kontaktzungen (31) in Winkelabständen zueinander rings um die Steckaufnahme (21) angeordnet sind, umfassend:
- Ansaugen der Kontaktvorrichtung (20) anhand des Bestückungswerkzeugs (300)
- Platzieren der Kontaktvorrichtung (20) an der Leiterplatte (80) und
- Herstellen einer Lötverbindung zwischen der Leiterplatte (80) und der Kontaktvorrichtung (20), insbesondere dem Befestigungsflansch (22) der Kontaktvorrichtung (20).
